# EUROPEAN PATENT SPECIFICATION

(11) **EP 2 022 719 B1**
(45) Date of publication and mention of the grant of the patent: **15.09.2010**
(21) Application number: 08160401.9
(22) Date of filing: 15.07.2008
(51) Int. Cl.: B64G 1/44, C08J 7/12, C08J 7/18, H01L 31/00

(54) **Method for stabilizing silicone material, stabilized silicone material, and devices incorporating that material**
Verfahren zur Stabilisierung von Silikonmaterial, stabilisiertes Silikonmaterial und Vorrichtungen mit diesem Material
Procédé pour la stabilisation de matériau de silicone, matériau de silicone stabilisé et dispositifs incorporant ce matériau

(30) Priority: 25.07.2007 US 782681
(43) Date of publication of application: 11.02.2009
(73) Proprietor: United Solar Ovonic LLC, Auburn Hills, MI 48326 (US)
(72) Inventor: Liu, Shengzhong, Rochester Hills, MI 48309 (US); Banerjee, Arindam, Bloomfield Hills, MI 48302 (US); Yang, Chi, Troy, MI 48098 (US); Guha, Subhendu, Bloomfield Hills, MI 48304 (US); Hu, Chaolan, Rochester Hills, MI 48306 (US)
(74) Representative: Høiberg A/S

(56) References cited:
- US-A- 4 900 582
- US-A1- 2006 207 646
- US-B1- 6 265 462

## Description

### FIELD OF THE INVENTION

This invention relates generally to materials. More particularly the invention relates to silicone containing materials which are stabilized against the light induced formation of chromophores, and to methods for the reversal of light induced color formation in silicone containing materials.

### BACKGROUND OF THE INVENTION

Silicone containing polymers are prepared by the polymerization of organosilicon monomers. These materials are broadly defined as polyorganosiloxanes and are also referred to as silicones. Silicone containing polymers are chemically inert, flexible, electrically insulating, and have good mechanical strength. Furthermore, these materials can be fabricated to be optically transparent. As a consequence, silicone materials are frequently used as protective or passivating coatings in a large variety of applications. In particular, silicone coatings are used with advantage as protective coatings in photovoltaic devices and other optical and optoelectronic devices. Published U.S. Patent Application 2006/0207646 filed July 2, 2004, and entitled "Encapsulation of Solar Cells" discloses the use of silicone coatings for protecting photovoltaic devices. The disclosure of this patent application is incorporated herein by reference. In the context of this disclosure, silicone materials are understood to comprise all materials which include silicones. For example silicone materials include silicone polymers, as well as copolymers of silicones and other materials, as well as blends of materials which include silicones. Therefore, all of such materials are understood to comprise silicone containing materials or silicone materials, said terms being used interchangeably.

The light weight, flexibility and durability of silicone coatings makes them good candidates for use in lightweight, flexible photovoltaic devices intended for stratospheric and outer space applications. Such teaching is found in U.S. Patent Application Serial No. 11/656,151 filed January 22, 2007, entitled "Solar Cells for Stratospheric and Outer Space Use,"

While silicone coatings have many properties which make them ideally suited for stratospheric and outer space uses, it has been found that when such coatings are exposed to ultraviolet radiation in the absence of oxygen they tend to form chromophoric species which absorb in the visible portions of the electromagnetic spectrum. As is generally understood in the art, the visible electromagnetic spectrum ranges from approximately 400 to 700 nm; although, some persons have a greater visual sensitivity and can perceive light ranging from 380 to 780 nm. In any instance, such darkening of a silicone protective coating is very detrimental to the operation of a photovoltaic device in which it is incorporated, since such darkening attenuates the amount of light available for the generation of photocurrents.

As will be appreciated, ultraviolet induced darkening of silicone coatings is a significant problem in high stratospheric and outer space applications, since they are exposed to high levels of ultraviolet radiation. Consequently, there is a need for methods and/or materials which can minimize or prevent, or reverse, such light induced darkening in silicone coatings. As will be explained in detail hereinbelow, the present invention provides materials and methods which prevent, minimize, and reverse darkening of silicone materials caused by ultraviolet induced chromophore formation.

### BRIEF DESCRIPTION OF THE INVENTION

Disclosed is a method for minimizing or reversing the formation of light absorbing species in a silicone containing material, caused by exposure to ultraviolet radiation. The method comprises exposing the material to an atmosphere containing a reactive species such as activated oxygen, ozone, other oxygen containing species such as nitrates or nitrous oxide, as well as hydrogen, atomic hydrogen, and protons. Exposure of the material to the reactive species prior to exposure to the ultraviolet radiation will prevent or minimize the formation of the visible light absorbing species. In materials which have already been darkened by ultraviolet radiation, exposure to the reactive species will reverse the darkening effect.

The exposure to the reactive species may be accomplished by exposing the coating to an oxygen containing atmosphere, such as air, oxygen, or a blend of oxygen with other gases, while illuminating the material with ultraviolet radiation having a wavelength in the range of 250-350 nm. In other instances, the reactive species may comprise ozone, or ionized oxygen. The reactive species may also comprise oxygen containing species such as nitrous oxide or nitrates, halogens, atomic hydrogen, protons, or other such species, and may be generated remote from the silicone material, and then brought into contact with it.

In particular instances, the silicone material, prior to treatment, has an absorption peak in the range of 250-270 nm, and the step of exposing the material to the reactive species comprises exposing said material for a period of time sufficient to decrease the intensity of that absorption peak by at least 50%.

Also disclosed are silicone coatings which are stabilized against ultraviolet induced darkening, and which are prepared in accord with the foregoing, as well as photovoltaic devices which incorporate those coatings.

### DETAILED DESCRIPTION OF THE INVENTION

It has been found that exposure of silicone materials to an atmosphere which contains activated oxygen or other reactive species will prevent the optical darkening of those materials when they are subsequently exposed to ultraviolet radiation in a low oxygen environment, and in particular to high energy, relatively short wavelength ultraviolet radiation such as vacuum ultraviolet radiation. It has further been found that silicone materials which have previously been darkened by exposure to ultraviolet radiation can have some, or all, of their transparency restored by subsequently exposing them to reactive species. The reactive species which may be used in this invention include activated oxygen, including ozone, oxygen containing species, and halogens, as well as other species such as atomic hydrogen, protons, or other reactive, energetic particles. Materials such as the halogens or oxygen containing species may be further activated by an energetic input and may or may not be ionized.

This invention will be described with regard to the use of activated oxygen, and it is to be understood that other reactive species may likewise be employed. In the context of this disclosure, activated oxygen comprises oxygen having an energy greater than that of ground state O₂. Activated oxygen may comprise ozone (O₃) or it may comprise some other form of oxygen which is in an electronically excited state, and as such includes neutral oxygen as well as ionized oxygen. In one particular instance, the activated oxygen may be provided by the illumination of oxygen with ultraviolet radiation. For example, it has been found that treatment may be accomplished by disposing the silicone material in an oxygen containing atmosphere, and illuminating that material with ultraviolet radiation. In some specific instances, this radiation has a wavelength in the range of 200-350 nm. The oxygen containing atmosphere may be air, pure oxygen, or a blend of oxygen with another gas. In other instances, the activated oxygen may be provided from an ozone generator disposed either proximate to, or separate from, the coating being treated. In yet other instances activated oxygen may be provided by electromagnetic excitation of oxygen as for example in a plasma generator.

As will be detailed hereinbelow, the exposure to activated oxygen inhibits or reverses the formation of visible light absorbing species in the silicone material. While not wishing to be bound by speculation, it is theorized that the activated oxygen interacts with certain atoms or molecules in the silicone material thereby preventing the formation of color generating species, or destroying species previously formed.

Typical silicones comprise polyorganosiloxane polymers, as are represented by the material commercially available from the Dow Corning corporation under the designator "DC 1-2620" for example. Spectrophotometric analysis of these materials shows that they initially have a light absorption peak in the range of 250-270 nm. This peak is approximately centered at 265 nm. When the silicone material is exposed to activated species, this peak is decreased or eliminated. The decrease of this peak has been correlated with subsequent resistance to the formation of visible light absorbing species in the material when it is subsequently exposed to short wavelength ultraviolet radiation. On this basis, it is postulated that the species generating this peak can enter into an ultraviolet radiation induced reaction which leads to the formation of light absorbing species, and prior reaction with reactive materials such as activated oxygen alters the species to render it inactive.

In general, it has been found that silicone materials of the type used as coatings in photovoltaic devices can be stabilized against ultraviolet induced darkening by exposure to activated oxygen under conditions, and for times, sufficient to significantly reduce the 250-270 nm absorption peak. In one particular instance, a good degree of stabilization is achieved by treatment sufficient to assure that the optical transparency of the silicone material at 265 nm is at least 70% of its transparency at 500 nm. The scope and duration of such treatment will depend upon the particular treatment mode. For example if treatment is being implemented utilizing ultraviolet radiation and air or some other such oxygen containing atmosphere, it has been found that illumination at wavelengths in the range of 250-350 nm for 1,000-3,000 equivalent solar hours (ESH) at a pressure of 0.05 bar (40 torr) as well as at atmospheric pressure will provide a very good degree of protection. Treatment may be accomplished in shorter time periods utilizing more activated forms of oxygen, higher partial pressures of oxygen, shorter ultraviolet wavelengths, or other intense sources of activation. This treatment with activated oxygen may be implemented before the silicone material is coated onto a photovoltaic device, or it may be implemented after coating. All of such modes and parameters will be apparent to those of skill in the art in view of the teaching presented herein.

A series of experiments were carried out to evaluate and illustrate certain aspects of the present invention. In this regard, a series of silicone films were coated onto quartz substrates. The coatings for this experimental series were prepared utilizing the aforedescribed Dow Coming VC 1-2620 product. This material was diluted with the manufacturer's suggested Dow Coming OS-30 solvent. The resultant mixture was spray coated onto a series of quartz substrates and cured. Curing was accomplished by heating to temperatures of at least 60°C. In some instances, the spray coated substrates were gradually heated from room temperature to the elevated temperature over a period of several hours. In other instances, multi-step heating was employed wherein the samples were first taken to a temperature of approximately 70°, held for a period of 15 minutes to several hours, and heated to the final temperature of at least 125°C. In yet other instances, samples were placed in an oven held at 125°C or higher and maintained in that oven for approximately 30 minutes. In all instances, excellent coatings were produced, and all coatings met ASTM-E-595-93 (2003) standards for outgassing. The foregoing coatings were prepared to thicknesses of about 0.2 and 2 mil and subjected to further testing. Each of the coatings was paired with an uncoated, blank quartz substrate which functioned as a control, and the samples and controls were subjected to further testing.

In a first experimental series, silicone coatings of about 0.2 and 2 mm (mil) were exposed to a broadband ultraviolet radiation in an atmosphere of approximately 0.05 bar (40 torr) of air. These conditions approximated those which a high altitude aircraft (HAA) would encounter in the upper stratosphere. Exposure of these coatings to illumination of up to 2,000 equivalent sun hours (ESH) of ultraviolet radiation produced no notable darkening.

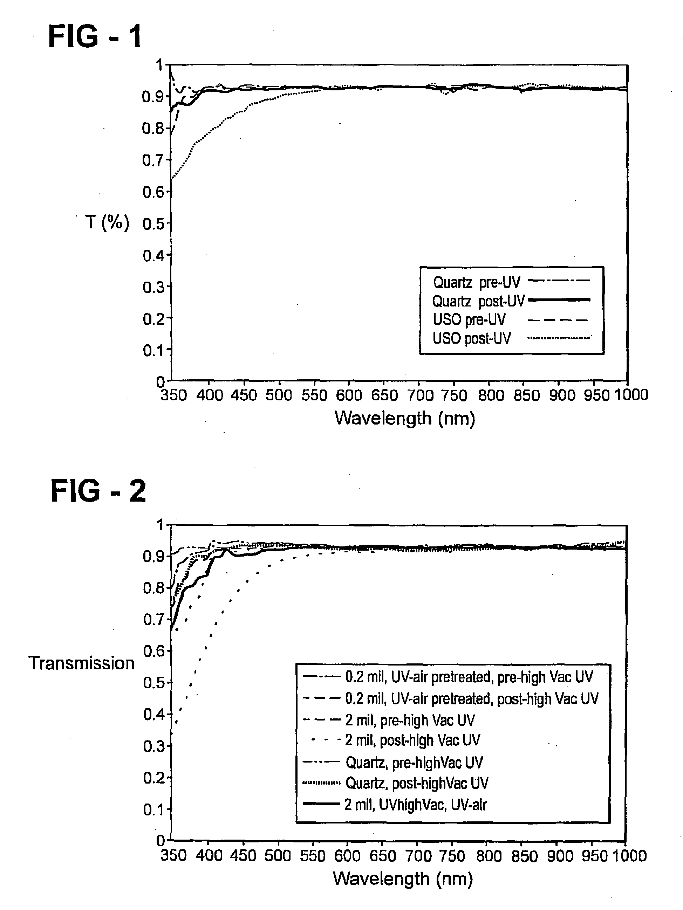

The foregoing experiment was rerun utilizing approximately 0.2 mm (mil) thickness silicone coatings and reference quartz disks; however, the atmosphere of air was replaced with an atmosphere of 0.05 bar (40 torr) of argon. Results of this experiment are shown in Figure 1. As will be seen therein, the quartz control sample has a high optical transparency over the range of 350-1,000 nm prior to ultraviolet exposure. Following exposure, the quartz showed essentially no change. The silicone coating initially showed very good optical transparency over the whole range; but, following the ultraviolet exposure, it manifests significant light absorption over the range of 350-550 nm. As discussed above, this darkening is detrimental to the efficient operation of a photovoltaic device. The experimental series was rerun utilizing the 2 mm (mil) thick silicone coating, and very similar results were found.

A further experimental series was carried out and the results thereof are summarized in the graph of Figure 2. In this experimental series, two sets of approximately 0.2 and 2 mm ( mil) thick silicone films were prepared on a quartz substrate. One set of the two thicknesses of films was pretreated with activated oxygen by exposure to the broadband ultraviolet radiation in air at a pressure of 0.05 bar (40 torr) for approximately 1,000 ESH. Thereafter, the samples were exposed in vacuum to ultraviolet radiation for another 1,000 ESH. It is significant to note that in the pretreated samples, darkening was inhibited. For example, in Figure 2, the 0.2 mm (mil) thickness coating showed a darkening which was not significantly different from that manifested by the bare quartz control sample. The 2 mm (mil) thick coating likewise showed very little darkening, as compared to the corresponding coating which was not pretreated and which had very significant absorption. From the foregoing, it will be seen that pretreatment of silicone coatings with activated oxygen significantly inhibits the generation of physical light absorbing species in such coatings. In the foregoing example, the oxygen pretreatment took place under an atmosphere of low pressure air. Treatment at higher oxygen concentrations will produce similar results in a quicker time. Likewise, treatment with other activated oxygen species such as ozone, and plasmas, will produce similar results. Also, while the foregoing examples describe a process in which treatment with activated oxygen was employed for the purpose of preventing or minimizing the darkening of a silicone coating, it has been found that a similar treatment will reverse the darkening of silicone coatings which have been exposed to ultraviolet radiation.

While the foregoing experimental series employed one particular silicone material, it is to be understood that the methods disclosed herein may be utilized in conjunction with all silicone containing materials. The silicone materials may be exposed to activated oxygen either before or after being coated onto substrates. It is to be understood that other reactive species may, in some instances, be substituted for the activated oxygen. Such agents may include halogens, as well as oxygen containing species such as nitrates and nitrous oxide as well as atomic hydrogen, and protons. While the foregoing has been described with reference to methods and materials used for encapsulating photovoltaic devices, it is to be understood that silicone based coatings have a number of uses wherein they are exposed to intense ultraviolet radiation, and the methods and materials of this invention may be readily adapted to such applications.

## Claims

1. A method for minimizing or reversing the formation of visible light absorbing species in a silicone containing material caused by exposure to ultraviolet radiation, said method comprising the step of:
exposing said silicone containing material to a reactive species.

2. The method of claim 1, wherein said reactive species is selected from the group consisting of: activated oxygen, an oxygen containing species, a halogen, atomic hydrogen, protons, and combinations thereof.

3. The method of claim 1, wherein said reactive species comprises activated oxygen.

4. The method of claim 3, wherein said step of exposing said silicone containing material to activated oxygen comprises:
exposing said material to an oxygen containing atmosphere while illuminating said material with ultraviolet radiation having a wavelength in the range of 200-350 nm.

5. The method of claim 4, wherein said oxygen containing atmosphere is air.

6. The method of claim 1, wherein said step of exposing said silicone containing material to said reactive species comprises:
exposing said material to said reactive species prior to the time said material is exposed to high energy ultraviolet radiation, whereby exposure of said material inhibits the formation of visible light absorbing species therein.

7. The method of claim 1, wherein the step of exposing said silicone containing material to said reactive species comprises:
exposing said material to said reactive species after said material has been exposed to said ultraviolet radiation, whereby said exposure reverses, at least in part, the formation of visible light absorbing species in said material.

8. The method of claim 1, wherein said silicone containing material is a polyorganosiloxane.

9. The method of claim 1, wherein said silicone containing material has an absorption peak at 250-270 nm, and wherein said step of exposing said material to said reactive species comprises exposing said material for a period of time sufficient to reduce the intensity of that peak by at least 50%.

10. The method of claim 1, wherein said step of exposing said silicone containing material comprises exposing said material in air to ultraviolet radiation in the wavelength range of 250-350 nm the amount of said radiation being in the range of 1,000-3,000 equivalent solar hours (ESH).

11. The method of claim 1, wherein the step of exposing said silicone containing material to said reactive species comprises:
exposing said material to an atmosphere which includes ozone.

12. A method for passivating a silicone containing material which is intended to be exposed to high intensity ultraviolet radiation so as to prevent or minimize the formation of visible light absorbing species therein, said method comprising the step of:
exposing said material to a reactive species.

13. The method of claim 12, including the further step of coating said silicone material onto a substrate after it has been exposed to said atmosphere containing an activated oxygen species.

14. The method of claim 12, including the further step of coating said silicone material onto a substrate prior to the time it is exposed to said atmosphere containing an activated oxygen species.

15. The method of claim 12, wherein said reactive species comprises activated oxygen.

16. The method of claim 12, wherein said reactive species is selected from the group consisting of: activated oxygen, an oxygen containing species, a halogen, atomic hydrogen, protons, and combinations thereof.

17. A silicone material having a decreased tendency to form visible light absorbing species when exposed to vacuum ultraviolet radiation, said coating being **characterized in that** its optical transparency at 265 nm is at least 70% of its transparency at 500 nm.

18. A photovoltaic device having the material of claim 17 coated thereupon.

## Patentansprüche

1. Verfahren zum Verringern oder Umkehren der Bildung einer sichtbares Licht absorbierenden Spezies in einem Silikon enthaltendem Material, die durch Aussetzung an ultraviolette Strahlung verursacht wird, wobei das Verfahren den Schritt umfasst:
Aussetzen des Silikon enthaltenden Materials einer reaktiven Spezies.

2. Verfahren nach Anspruch 1, wobei die reaktive Spezies ausgewählt ist aus der Gruppe bestehend aus aktiviertem Sauerstoff, einer Sauerstoff enthaltenden Spezies, einem Halogen, atomarem Wasserstoff, Protonen und Kombinationen davon.

3. Verfahren nach Anspruch 1, wobei die reaktive Spezies aktivierten Sauerstoff umfasst.

4. Verfahren nach Anspruch 3, wobei der Schritt eines Aussetzens des Silikon enthaltenden Materials einem aktivierten Sauerstoff umfasst:
Aussetzen des Materials einer Sauerstoff enthaltenden Atmosphäre, während das Material mit ultravioletter Strahlung mit einer Wellenlänge in dem Bereich von 200-300 nm bestrahlt wird.

5. Verfahren nach Anspruch 4, wobei die Sauerstoff enthaltende Atmosphäre Luft ist.

6. Verfahren nach Anspruch 1, wobei der Schritt eines Aussetzens des Silikon enthaltenden Materials der reaktiven Spezies umfasst:
Aussetzen des Materials der reaktiven Spezies vor dem Zeitpunkt bevor das Material hochenergetischer ultravioletter Strahlung ausgesetzt wird, wobei die Aussetzung des Materials die Bildung von sichtbares Licht absorbierenden Spezies darin hemmt.

7. Verfahren nach Anspruch 1, wobei der Schritt eines Aussetzens des Silikon enthaltenden Materials der reaktiven Spezies umfasst:
Aussetzen des Materials der reaktiven Spezies nachdem das Material mit der ultravioletten Strahlung bestrahlt wurde, wobei die Bestrahlung zumindest teilweise die Bildung sichtbares Licht absorbierenden Spezies in dem Material umkehrt.

8. Verfahren nach Anspruch 1, wobei das Silikon enthaltende Material ein Polyorganosiloxan ist.

9. Verfahren nach Anspruch 1, wobei das Silikon enthaltende Material ein Absorptionsmaximum bei 250-270 nm aufweist, und wobei der Schritt eines Aussetzens des Materials der reaktiven Spezies umfasst, Aussetzen des Materials für eine Zeitdauer, die ausreichend ist, die Intensität des Maximums um mindestens 50 % zu verringern.

10. Verfahren nach Anspruch 1, wobei der Schritt eines Aussetzens des Silikon enthaltenden Materials umfasst, Aussetzen des Materials einer ultravioletten Strahlung mit einem Wellenlängenbereich von 250-350 nm in Luft, wobei die Menge der Strahlung in dem Bereich von 1.000-3.000 Sonnenstundenäquivalenten (ESH) liegt.

11. Verfahren nach Anspruch 1, wobei der Schritt eines Aussetzens des Silikon enthaltenden Materials der reaktiven Spezies umfasst,
Aussetzen des Materials einer Atmosphäre, die Ozon umfasst.

12. Verfahren zum Passivieren eines Silikon enthaltenden Materials, das dazu vorgesehen ist, einer hochenergetischen ultravioletten Strahlung ausgesetzt zu werden, um so die Bildung von sichtbares Licht absorbierenden Spezies darin zu verhindern oder zu verringern, wobei das Verfahren den Schritt umfasst,
Aussetzen des Materials einer reaktiven Spezies.

13. Verfahren nach Anspruch 12, weiter umfassend den Schritt eines Beschichtens des Silikonmaterials auf ein Substrat, nachdem es der Atmosphäre, die eine aktivierte Sauerstoffspezies umfasst, ausgesetzt wurde.

14. Verfahren nach Anspruch 12, weiter umfassend den Schritt eines Beschichtens des Silikonmaterials auf ein Substrat, bevor es der Atmosphäre, die eine aktivierte Sauerstoffspezies umfasst, ausgesetzt wird.

15. Verfahren nach Anspruch 12, wobei die reaktive Spezies aktivierten Sauerstoff umfasst.

16. Verfahren nach Anspruch 12, wobei die reaktive Spezies ausgewählt ist aus der Gruppe bestehend aus aktiviertem Sauerstoff, einer Sauerstoff enthaltenden Spezies, einem Halogen, atomarem Wasserstoff, Protonen und Kombinationen davon.

17. Silikonmaterial mit einer verringerten Tendenz, sichtbares Licht absorbierende Spezies zu bilden, wenn es unter Vakuum ultravioletter Strahlung ausgesetzt wird, wobei die Beschichtung **dadurch gekennzeichnet ist, dass** deren optische Transparenz bei 265 nm mindestens 70 % von deren Transparenz bei 500 nm beträgt.

18. Photovoltaische Einrichtung mit dem Material nach Anspruch 17, das darauf beschichtet ist.

## Revendications

1. Procédé pour minimiser ou inverser la formation d'espèce absorbant la lumière visible dans un matériau contenant de la silicone provoquée par une exposition à un rayonnement ultraviolet, ledit procédé comprenant l'étape consistant à :
exposer ledit matériau contenant de la silicone à une espèce réactive.

2. Procédé selon la revendication 1, dans lequel ladite espèce réactive est sélectionnée dans le groupe consistant en : de l'oxygène activé, une espèce contenant de l'oxygène, un halogène, de l'hydrogène en état atomique, des protons et des combinaisons de ceux-ci.

3. Procédé selon la revendication 1, dans lequel ladite espèce réactive comprend de l'oxygène activé.

4. Procédé selon la revendication 3, dans lequel ladite étape d'exposition dudit matériau contenant de la silicone à de l'oxygène activé consiste à :
exposer ledit matériau à une atmosphère contenant de l'oxygène tout en éclairant ledit matériau avec un rayonnement ultraviolet ayant une longueur d'onde dans la plage de 200 à 350 nm.

5. Procédé selon la revendication 4, dans lequel ladite atmosphère contenant de l'oxygène consiste en de l'air.

6. Procédé selon la revendication 1, dans lequel ladite étape d'exposition dudit matériau contenant de la silicone à ladite espèce réactive consiste à :
exposer ledit matériau à ladite espèce réactive avant l'instant auquel ledit matériau est exposé à un rayonnement ultraviolet de forte énergie, moyennant quoi l'exposition dudit matériau empêche la formation d'espèce absorbant la lumière visible dans celui-ci.

7. Procédé selon la revendication 1, dans lequel l'étape d'exposition dudit matériau contenant de la silicone à ladite espèce réactive consiste à :
exposer ledit matériau à ladite espèce réactive après que ledit matériau a été exposé audit rayonnement ultraviolet, moyennant quoi ladite exposition inverse, au moins en partie, la formation d'espèce absorbant la lumière visible dans ledit matériau.

8. Procédé selon la revendication 1, dans lequel ledit matériau contenant de la silicone est un polyorganosiloxane.

9. Procédé selon la revendication 1, dans lequel ledit matériau contenant de la silicone a un pic d'absorption à 250 à 270 nm, et dans lequel ladite étape d'exposition dudit matériau à ladite espèce réactive consiste à exposer ledit matériau pendant une période de temps suffisante pour réduire l'intensité de ce pic d'au moins 50 %.

10. Procédé selon la revendication 1, dans lequel ladite étape d'exposition dudit matériau contenant de la silicone consiste à exposer ledit matériau dans l'air à un rayonnement ultraviolet dans la plage de longueur d'onde de 250 à 350 nm, la quantité dudit rayonnement étant dans la plage de 1 000 à 3 000 heures équivalentes soleil (ESH).

11. Procédé selon la revendication 1, dans lequel l'étape d'exposition dudit matériau contenant de la silicone à ladite espèce réactive consiste à :
exposer ledit matériau à une atmosphère qui comprend de l'ozone.

12. Procédé de passivation d'un matériau contenant de la silicone qui est destiné à être exposé à un rayonnement ultraviolet de forte intensité de manière à empêcher ou minimiser la formation d'espèce absorbant la lumière visible dans celui-ci, ledit procédé comprenant l'étape consistant à :
exposer ledit matériau à une espèce réactive.

13. Procédé selon la revendication 12, comprenant l'étape supplémentaire consistant à déposer ledit matériau à base de silicone sur un substrat après qu'il a été exposé à ladite atmosphère contenant une espèce oxygénée activée.

14. Procédé selon la revendication 12, comprenant l'étape supplémentaire consistant à déposer ledit matériau à base de silicone sur un substrat avant l'instant auquel il est exposé à ladite atmosphère contenant une espèce oxygénée activée.

15. Procédé selon la revendication 12, dans lequel ladite espèce réactive comprend de l'oxygène activé.

16. Procédé selon la revendication 12, dans lequel ladite espèce réactive est sélectionnée dans le groupe consistant en : de l'oxygène activé, une espèce contenant de l'oxygène, un halogène, de l'hydrogène en état atomique, des protons et des combinaisons de ceux-ci.

17. Matériau à base de silicone ayant une tendance réduite à former une espèce absorbant la lumière visible lorsqu'il est exposé à un rayonnement ultraviolet sous vide, ledit dépôt étant **caractérisé en ce que** sa transparence optique à 265 nm est égale à au moins 70 % de sa transparence à 500 nm.

18. Dispositif photovoltaïque sur lequel est déposé le matériau selon la revendication 17.
